# EUROPÄISCHE PATENTANMELDUNG

(11) **EP 4 632 394 A1**
(43) Veröffentlichungstag der Anmeldung: **15.10.2025**
(21) Anmeldenummer: 24169746.5
(22) Anmeldetag: 11.04.2024
(51) Int. Cl.: G01R 31/26

(54) **VERFAHREN ZUM PRÄDIZIEREN EINES ZUKÜNFTIGEN FEHLERS EINES ELEKTRONISCHEN BAU-TEILS**

(71) Anmelder: Robert Bosch GmbH, 70442 Stuttgart (DE)
(72) Erfinder: Steimer, Andreas, 75328 Schoemberg (DE)

(57) **Zusammenfassung**

Die Erfindung betrifft ein Verfahren (100) zum Prädizieren eines zukünftigen Fehlers eines elektronischen Bauteils (1), umfassend die nachfolgenden Schritte:
- Bereitstellen (101) von Prüfdaten des elektronischen Bauteils (1), wobei die Prüfdaten aus einer elektrischen und/oder mechanischen Funktionsprüfung des elektronischen Bauteils (1) im Rahmen eines Wafer-Tests resultieren,
- Bestimmen (102) eines prädizierten Vorliegens eines Fehlers zum Zeitpunkt der Funktionsprüfung auf Basis der bereitgestellten Prüfdaten unter Verwendung eines trainierten Maschinenlernmodells, wobei das trainierte Maschinenlernmodell wenigstens einen Folgeprozesses nach dem Wafer-Test modelliert, wobei das prädizierte Vorliegen des Fehlers eine Wahrscheinlichkeit berücksichtigt, dass durch den wenigstens einen Folgeprozess ein Fehler des elektronischen Bauteils (1) hervorgerufen wird,
- Prädizieren (103) des zukünftigen Fehlers auf Basis des bestimmten prädizierten Vorliegens des Fehlers.

Ferner betrifft die Erfindung ein Computerprogramm, eine Vorrichtung sowie ein Speichermedium zu diesem Zweck.

## Beschreibung

Die Erfindung betrifft ein Verfahren zum Prädizieren eines zukünftigen Fehlers eines elektronischen Bauteils. Ferner betrifft die Erfindung ein Computerprogramm, eine Vorrichtung sowie ein Speichermedium zu diesem Zweck.

### Stand der Technik

Zur Vermeidung unnötiger Kosten im Bereich der Halbleiterfertigung ist die Vorhersage von Ergebnissen im sogenannten finalen Test (englisch: "Final Test", FT) aus Daten des sogenannten Wafer-Tests oder Wafer-Level Tests (WLT) von großer Wichtigkeit. Allerdings wird die Realisierung eines solchen Klassifikators dadurch massiv erschwert, dass die vorhandenen Klassifikationslabels des finalen Tests, die angeben, ob ein Halbleiterbauteil den finalen Test bestanden hat und damit noch funktionstüchtig ist oder nicht, nicht nur von der erfolgreichen Durchführung des vorangegangenen Prozessschritts zum Wafer-Test abhängen, sondern auch von unbekannten Prozessvorhängen, beispielsweise externer (Verpackungs-)Dienstleister, welche die Halbleiterbauteile zwischen Wafer-Test und finalen Test in Plastikgehäuse verpacken, wobei zusätzliche Ausfälle in den Bauteilen entstehen können.

### Offenbarung der Erfindung

Gegenstand der Erfindung ist ein Verfahren mit den Merkmalen des Anspruchs 1, ein Computerprogramm mit den Merkmalen des Anspruchs 8, eine Vorrichtung mit den Merkmalen des Anspruchs 9 sowie ein computerlesbares Speichermedium mit den Merkmalen des Anspruchs 10. Weitere Merkmale und Details der Erfindung ergeben sich aus den jeweiligen Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit dem erfindungsgemäßen Computerprogramm, der erfindungsgemäßen Vorrichtung sowie dem erfindungsgemäßen computerlesbaren Speichermedium, und jeweils umgekehrt, so dass bezüglich der Offenbarung der Erfindung stets auch eine wechselseitige Bezugnahme möglich ist.

Gegenstand der Erfindung ist insbesondere ein Verfahren zum Prädizieren eines zukünftigen Fehlers, insbesondere Produktionsfehlers, eines elektronischen Bauteils, umfassend die nachfolgenden Schritte, wobei die Schritte wiederholt und/oder nacheinander durchgeführt werden können.

In einem ersten Schritt werden vorzugsweise Prüfdaten des elektronischen Bauteils bereitgestellt, wobei die Prüfdaten aus einer elektrischen und/oder mechanischen Funktionsprüfung des elektronischen Bauteils im Rahmen eines Wafer-Tests resultieren. Der Wafer-Test kann im Rahmen der vorliegenden Erfindung auch als Wafer-Level-Test bezeichnet werden. Der Wafer-Test ist insbesondere eine Funktionsprüfung im Fertigungsablauf der Halbleitertechnik bei der Produktion von Halbleiterbauteilen wie integrierten Schaltungen. Dieser kann an einem jeweiligen noch nicht zerteilten Wafer durchgeführt werden, um fehlerhafte Schaltungen frühzeitig zu erkennen. Dafür kann der Wafer beispielsweise in ein Testgerät wie einem Wafer-Prober eingelegt werden, in dem Kontaktnadeln eine Verbindung zu den Test-Pads der einzelnen Schaltung herstellen.

In einem weiteren Schritt wird vorzugsweise ein prädiziertes Vorliegen eines Fehlers zum Zeitpunkt der Funktionsprüfung auf Basis der bereitgestellten Prüfdaten unter Verwendung eines trainierten Maschinenlernmodells bestimmt. Das trainierte Maschinenlernmodell modelliert dafür vorzugsweise wenigstens einen Folgeprozess nach dem Wafer-Test. Das Modellieren erfolgt insbesondere in Form einer binären Zufallsvariable. Das prädizierte Vorliegen des Fehlers berücksichtigt insbesondere eine Wahrscheinlichkeit, dass durch den wenigstens einen Folgeprozess ein Fehler des elektronischen Bauteils hervorgerufen wird. Vereinfacht ausgedrückt repräsentiert das prädizierte Vorliegen des Fehlers insbesondere, ob zum Zeitpunkt der Funktionsprüfung im Rahmen des Wafer-Tests eigentlich schon ein Fehler vorliegt, welcher durch den wenigstens einen Folgeprozess hervorgerufen werden wird. Dieser Fehler kann als Potential oder eine Wahrscheinlichkeit für einen Fehler verstanden werden, da das jeweilige elektronische Bauteil zwar in der Funktionsprüfung für okay befunden werden kann, allerdings dafür prädestiniert sein kann, durch den wenigstens einen Folgeprozess den Fehler zu erhalten. Das prädizierte Vorliegen des Fehlers kann als ein entsprechendes Klassifikationslabel repräsentiert sein.

In einem weiteren Schritt wird vorzugsweise der zukünftige Fehler auf Basis des bestimmten prädizierten Vorliegens des Fehlers prädiziert. Wenn das prädizierte Vorliegen des Fehlers bekannt ist, kann demnach daraus vorteilhaft der zukünftige Fehler abgeleitet, bzw. prädiziert werden. Dies kann eine Angabe einer Wahrscheinlichkeit umfassen, beispielsweise dass bei einem elektronischen Bauteil mit einer Wahrscheinlichkeit von 70 % durch den wenigstens einen Folgeprozess ein Fehler entstehen wird. So kann eine genauere Analyse und Prädiktion von Fehlern im Rahmen der Produktion von elektronischen Bauteilen ermöglicht werden.

Ferner ist es denkbar, dass das Maschinenlernmodell auf Basis eines Trainings mit den folgenden Schritten trainiert wurde:
- Bereitstellen von ersten Trainingsdaten, wobei die ersten Trainingsdaten im Rahmen einer elektrischen und/oder mechanischen Funktionsprüfung einer Vielzahl von elektronischen Bauteilen im Rahmen eines Wafer-Tests ermittelt werden,
- Bereitstellen von zweiten Trainingsdaten, wobei die zweiten Trainingsdaten im Rahmen einer elektrischen und/oder mechanischen Funktionsprüfung der Vielzahl von elektronischen Bauteilen im Rahmen einer finalen Prüfung nach dem wenigstens einen Folgeprozess nach dem Wafer-Test ermittelt werden,
- Ermitteln einer ersten Wahrscheinlichkeitsverteilung für eine Veränderung des Vorliegens des Fehlers vom Zeitpunkt des Wafer-Tests bis zum Zeitpunkt der finalen Prüfung auf Basis der bereitgestellten ersten und zweiten Trainingsdaten,
- Ermitteln einer zweiten Wahrscheinlichkeitsverteilung für ein jeweiliges prädiziertes Vorliegen des Fehlers zum Zeitpunkt der Funktionsprüfung im Rahmen des Wafer-Tests auf Basis der ersten und zweiten Trainingsdaten und der ersten Wahrscheinlichkeitsverteilung, wobei das prädizierte Vorliegen des Fehlers eine Wahrscheinlichkeit für die Veränderung des Vorliegens des Fehlers vom Zeitpunkt des Wafer-Tests bis zum Zeitpunkt der finalen Prüfung berücksichtigt.

Die elektrische und/oder mechanische Funktionsprüfung im Rahmen der finalen Prüfung, bzw. die finale Prüfung, kann im Rahmen der vorliegenden Erfindung auch als finaler Test bezeichnet werden. Dieser finale Test schließt sich insbesondere an den wenigstens einen Folgeprozess, wie beispielsweise einen Verpackungsprozess, an. Die ersten Trainingsdaten können jeweilige Messdaten der Vielzahl von elektronischen Bauteilen im Rahmen des Wafer-Tests umfassen. Die zweiten Trainingsdaten können jeweilige Messdaten der Vielzahl von elektronischen Bauteilen im Rahmen der finalen Prüfung und/oder entsprechende Labels, welche angeben ob ein jeweiliges elektronisches Bauteil die finale Prüfung bestanden hat, umfassen.

In einer weiteren Möglichkeit kann vorgesehen sein, dass das Maschinenlernmodell ein Modell zur Klassifikation unter verrauschten Labels ist und in dem Training desselben durch einen Expectation-Maximization Algorithmus angepasst wird. Ein verrauschtes Label (englisch: "noisy label") bezieht sich insbesondere auf ein Datenetikett oder eine Klassifikation, die fehlerhaft, ungenau oder anderweitig inkorrekt ist. Solche Labels können in Datensätzen vorkommen, die für maschinelles Lernen, insbesondere für überwachtes Lernen, verwendet werden. Die Präzision und Zuverlässigkeit der verwendeten Trainingsdaten können entscheidend für die Effektivität der darauf trainierten Modelle sein. Verrauschte Labels können durch verschiedene Faktoren verursacht werden, wie beispielsweise den wenigstens einen Folgeprozess im Rahmen der vorliegenden Erfindung oder auch menschliche Fehler bei der Datenannotation, Mehrdeutigkeit in den Daten selbst oder Fehler in der Datenerfassung.

Der Expectation-Maximization (EM) Algorithmus ist insbesondere ein iteratives Verfahren zur Schätzung von Maximum-Likelihood- oder Maximum-A-Posteriori (MAP)-Parametern in statistischen Modellen, insbesondere wenn das Modell unvollständige oder verborgene Daten enthält. Dieser Algorithmus kann vorteilhaft in Situationen eingesetzt werden, in denen die direkte Berechnung der maximalen Likelihood-Schätzungen aufgrund der Komplexität des Modells oder fehlender Daten nicht praktikabel ist. Der EM-Algorithmus teilt sich insbesondere in zwei Hauptphasen: Expectation (E)-Schritt: In dieser Phase wird vorzugsweise die erwartete Log-Likelihood-Funktion unter der aktuellen Schätzung der Parameter berechnet, wobei über die unbekannten Daten oder die verborgenen Variablen gemittelt wird. Das Ziel ist vorzugsweise, eine Funktion zu finden, die die Wahrscheinlichkeit (oder Likelihood) der beobachteten Daten maximiert, gegeben die momentanen Schätzungen der Modellparameter. Maximization (M)-Schritt: In diesem Schritt werden vorzugsweise die Parameter des Modells so angepasst, dass die im E-Schritt berechnete erwartete Log-Likelihood maximiert wird. Dies führt zu einer neuen Schätzung der Parameter, die dann im nächsten E-Schritt verwendet wird. Diese beiden Schritte werden bevorzugt iterativ wiederholt, bis eine Konvergenz erreicht ist, d.h., bis sich die Parameterwerte nicht mehr signifikant ändern oder die Verbesserung der Log-Likelihood zwischen aufeinanderfolgenden Iterationen unterhalb eines vorgegebenen Schwellenwerts liegt.

Des Weiteren ist es im Rahmen der Erfindung optional möglich, dass das Training unter Verwendung eines Boosted Tree-Verfahrens durchgeführt wird. Ein "Boosted Tree" ist insbesondere ein Ensemble-Lernverfahren, das darauf abzielt, die Vorhersagegenauigkeit zu verbessern, indem mehrere schwache Lernmodelle - speziell Entscheidungsbäume - kombiniert werden. Dies geschieht beispielsweise durch die sequenzielle Anwendung von schwachen Lernmodellen, bei der jedes Modell versucht, die Fehler seiner Vorgänger zu korrigieren. Der Begriff "Boosting" bezieht sich insbesondere auf diese Methode der schrittweisen Verbesserung. Im Kontext von Entscheidungsbäumen kann dies zur Erstellung eines starken Vorhersagemodells aus einer Kombination von mehreren schwachen Bäumen führen. Ein schwacher Lerner, welcher im Rahmen des Boosted Tree-Verfahrens verwendet werden kann, ist ein Modell, dessen Vorhersagegenauigkeit nur leicht besser ist als das Raten. Im Kontext von Boosted Trees sind diese schwachen Lerner beispielsweise einfache Entscheidungsbäume. Im Gegensatz zu anderen Ensemble-Methoden, wie dem Random Forest, bei dem die Bäume parallel gebaut werden, baut das Boosted Tree-Verfahren vorzugsweise die Bäume nacheinander auf. Jeder Baum wird insbesondere trainiert, um die verbleibenden Fehler des bisherigen Modells zu minimieren. Boosted Trees können die Gewichte von Beobachtungen anpassen, je nachdem, wie schwer sie zu prognostizieren sind. Beobachtungen, die von vorherigen Modellen falsch vorhergesagt wurden, erhalten vorzugsweise ein höheres Gewicht, so dass nachfolgende Modelle versuchen können, diese spezifisch besser zu prognostizieren. Eine spezielle Variante des Boosted Tree Verfahrens ist das Gradient Boosting. Hierbei können Gradienten im Verlustfunktionsraum verwendet werden, um die Richtung der Verbesserung für das nächste Modell anzugeben. Einfach ausgedrückt, passt insbesondere jedes neue Modell seine Vorhersagen an die residuellen Fehler der vorherigen Modelle an.

Nach einer weiteren Möglichkeit kann vorgesehen sein, dass das Ermitteln der zweiten Wahrscheinlichkeitsverteilung auf Basis einer probabilistischen Inferenz durchgeführt wird. Probabilistische Inferenz ist insbesondere ein statistisches Verfahren, das darauf abzielt, aus gegebenen Daten Schlussfolgerungen zu ziehen, indem Wahrscheinlichkeiten zugeordnet werden. Dieser Ansatz basiert beispielsweise auf der Annahme, dass Unsicherheit in der Beobachtung von Daten inhärent ist und durch Wahrscheinlichkeiten quantifiziert werden kann. Probabilistische Inferenz kann in der künstlichen Intelligenz, in maschinellen Lernmodellen und in der statistischen Datenanalyse verwendet werden, um Vorhersagen zu treffen, Entscheidungen unter Unsicherheit zu treffen und die Wahrscheinlichkeiten von bestimmten Ereignissen oder Zuständen zu schätzen. Der Prozess der probabilistischen Inferenz kann die Verwendung von Wahrscheinlichkeitsverteilungen zur Modellierung der Unsicherheiten in den Daten und der zugrundeliegenden Prozesse umfassen. Diese Verteilungen können dann genutzt werden, um posteriori Wahrscheinlichkeiten zu berechnen, die auf neuen Daten oder Beobachtungen basieren, unter Berücksichtigung der ursprünglichen, a priori Annahmen (Vorwissen). Es gibt verschiedene Methoden und Techniken der probabilistischen Inferenz, wie zum Beispiel die Bayessche Inferenz: Dies ist eine Methode der statistischen Inferenz, bei der Bayes' Theorem verwendet wird, um die Wahrscheinlichkeit für eine Hypothese zu aktualisieren, sobald mehr Informationen verfügbar werden. Ferner gibt es die Markov-Ketten-Monte-Carlo (MCMC): Eine Klasse von Algorithmen für die Näherung der Verteilung von Wahrscheinlichkeiten, insbesondere nützlich, wenn die direkte Berechnung komplex oder unmöglich ist. Zudem können grafische Modelle verwendet werden. Dazu gehören beispielsweise Bayessche Netzwerke und Markov-Netzwerke, die es ermöglichen können, komplexe Abhängigkeiten und Unsicherheiten zwischen verschiedenen Variablen in einem Datensatz zu modellieren und zu inferieren. Probabilistische Inferenz kann es ermöglichen, Entscheidungen zu treffen und Vorhersagen zu generieren, die die Unsicherheit und Variabilität in realen Daten berücksichtigen, was zu robusteren und zuverlässigeren Ergebnissen führen kann.

Des Weiteren ist es denkbar, dass der wenigstens eine Folgeprozess zumindest einen Verpackungsprozess des elektronischen Bauteils umfasst. Auch ist möglich dass der wenigstens eine Folgeprozess eine Logistik und/oder Distribution des elektronischen Bauteils umfasst, d.h. beispielsweise verschiedene Möglichkeiten des Versands und der Lagerung.

Ein weiterer Vorteil im Rahmen der Erfindung ist erzielbar, wenn das elektronische Bauteil ein Halbleiterbauteil ist und die Funktionsprüfung im Rahmen einer Halbleiterfertigung durchgeführt wird. Hier kann das erfindungsgemäße Verfahren besonders vorteilhaft sein, da hierbei häufig Fehler in dem wenigstens einen Folgeprozess, wie beispielsweise einem Verpackungsprozess, entstehen können.

Ebenfalls Gegenstand der Erfindung ist ein Computerprogramm, insbesondere Computerprogrammprodukt, umfassend Befehle, die bei der Ausführung des Computerprogrammes durch einen Computer diesen veranlassen, das erfindungsgemäße Verfahren auszuführen. Damit bringt das erfindungsgemäße Computerprogramm die gleichen Vorteile mit sich, wie sie ausführlich mit Bezug auf ein erfindungsgemäßes Verfahren beschrieben worden sind.

Ebenfalls Gegenstand der Erfindung ist eine Vorrichtung zur Datenverarbeitung, die eingerichtet ist, das erfindungsgemäße Verfahren auszuführen. Als die Vorrichtung kann bspw. ein Computer vorgesehen sein, welcher das erfindungsgemäße Computerprogramm ausführt. Der Computer kann wenigstens einen Prozessor zur Ausführung des Computerprogramms aufweisen. Auch kann ein nichtflüchtiger Datenspeicher vorgesehen sein, in welchem das Computerprogramm hinterlegt und von welchem das Computerprogramm durch den Prozessor zur Ausführung ausgelesen werden kann.

Ebenfalls Gegenstand der Erfindung kann ein computerlesbares Speichermedium sein, welches das erfindungsgemäße Computerprogramm aufweist und/oder Befehle umfasst, die bei der Ausführung durch einen Computer diesen veranlassen, das erfindungsgemäße Verfahren auszuführen. Das Speichermedium ist bspw. als ein Datenspeicher wie eine Festplatte und/oder ein nicht-flüchtiger Speicher und/oder eine Speicherkarte ausgebildet. Das Speichermedium kann z. B. in den Computer integriert sein.

Darüber hinaus kann das erfindungsgemäße Verfahren auch als ein computerimplementiertes Verfahren ausgeführt sein.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Fig. 1: eine schematische Visualisierung eines Verfahrens, eines elektronischen Bauteils, einer Vorrichtung, eines Speichermediums sowie eines Computerprogramms gemäß Ausführungsbeispielen der Erfindung,
- Fig. 2: eine schematische Darstellung eines Bayesian Network als Basis eines Klassifikators für verrauschte Labels gemäß Ausführungsbeispielen der vorliegenden Erfindung.

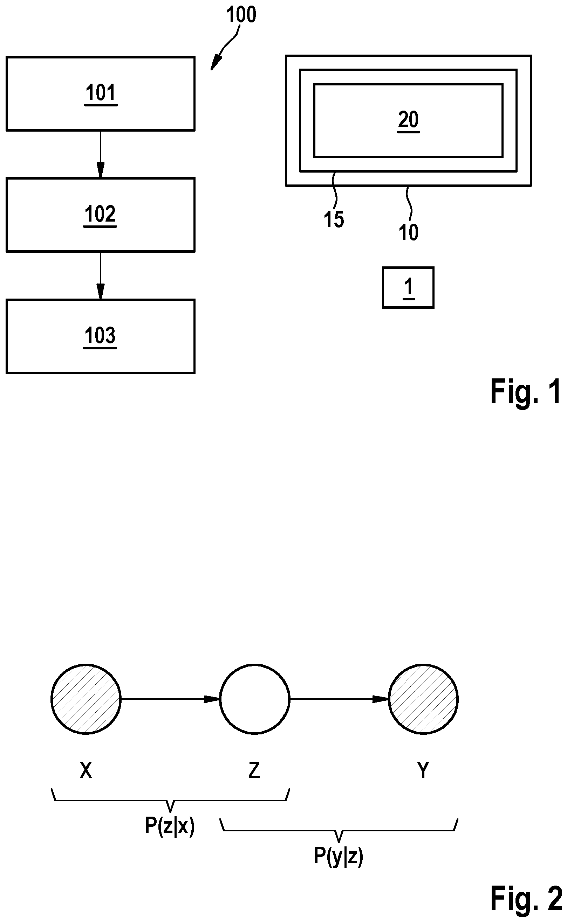

In Fig. 1 sind ein Verfahren 100, ein elektronisches Bauteil 1, eine Vorrichtung 10, ein Speichermedium 15 sowie ein Computerprogramm 20 gemäß Ausführungsbeispielen der Erfindung schematisch dargestellt.

Fig. 1 zeigt insbesondere ein Ausführungsbeispiel für ein Verfahren 100 zum Prädizieren eines zukünftigen Fehlers eines elektronischen Bauteils 1. In einem ersten Schritt 101 werden Prüfdaten des elektronischen Bauteils 1 bereitgestellt, wobei die Prüfdaten aus einer elektrischen und/oder mechanischen Funktionsprüfung des elektronischen Bauteils 1 im Rahmen eines Wafer-Tests resultieren. In einem zweiten Schritt 102 wird ein prädiziertes Vorliegen eines Fehlers zum Zeitpunkt der Funktionsprüfung auf Basis der bereitgestellten Prüfdaten unter Verwendung eines trainierten Maschinenlernmodells bestimmt, wobei das trainierte Maschinenlernmodell wenigstens einen Folgeprozesses nach dem Wafer-Test modelliert, wobei das prädizierte Vorliegen des Fehlers eine Wahrscheinlichkeit berücksichtigt, dass durch den wenigstens einen Folgeprozess ein Fehler des elektronischen Bauteils 1 hervorgerufen wird. In einem dritten Schritt 103 wird der zukünftige Fehler auf Basis des bestimmten prädizierten Vorliegens des Fehlers prädiziert.

Ein Aspekt der vorliegenden Erfindung ist es insbesondere unbekannte Prozessvorgänge, beispielsweise des externen Dienstleisters, als ein Problem verrauschter Klassenlabels zu modellieren bzw. zu interpretieren. Darüber hinaus kann dadurch die Möglichkeit entstehen, auf entsprechende Lösungsverfahren zum Trainieren von Klassifikatoren mittels verrauschter Labels zurückzugreifen.

Das Verfahren gemäß Ausführungsbeispielen basiert insbesondere auf einer Modellierung der dem Wafer-Test nachgelagerten Prozessvorgänge, beispielsweise des Verpackungs-Dienstleisters, als binäre Zufallsvariable, bei welchen die Möglichkeit besteht, dass ein im Wafer-Test noch funktionstüchtiges elektronisches Bauteil 1 zerstört wird und somit der NOK-Klasse (nicht funktionstüchtig) zugeordnet werden muss. Der umgekehrte Fall kann physikalisch-logisch ausgeschlossen werden. Die Wahrscheinlichkeit, dass dies geschieht wird insbesondere mit P(y|z) angegeben, wobei yε{OK, NOK} das im finalen Test empirisch ermittelte und zε{OK, NOK} dasjenige Label ist, welches im Wafer-Test tatsächlich hätte vergeben werden sollen.

z ist also insbesondere nicht das im Wafer-Test durch empirische Tests ermittelte Label, welches immer OK ist, da NOK-getestete Teile grundsätzlich aussortiert werden und somit nur solche Teile übrig bleiben, die OK in dem Wafer-Test waren, sondern das zur Wafer-Test-Zeit für den finalen Test existente Label. Die im Wafer-Test empirisch auf OK getesteten elektronischen Bauteile 1 wiederum zerfallen dabei beispielsweise in drei Klassen. Solche, deren Label schon zur Wafer-Test-Zeit OK war und die durch den wenigstens einen Folgeprozess wie den Verpackungsprozess nicht zerstört wurden und somit auch in dem finalen Test OK getestet worden sind (z = y = OK). Ferner gibt es elektronische Bauteile 1 die in dem finalen Test schadhaft sind und dies schon zur Wafer-Test-Zeit waren (z = NOK, y = NOK), sowie jene Teile, die erst während des wenigstens einen Folgeprozesses durch unbekannte Prozesse, beispielsweise eines Dienstleisters zerstört worden sind (z = OK, y = NOK).

Ein Maschinenlernmodell, insbesondere ein Klassifikator, wie z.B. boosted trees o.ä. modelliert vorzugsweise die Verteilung P(z|x), wobei x gemessene Werte im Wafer-Test sein können und P(y|z) die Wahrscheinlichkeiten dafür, dass ein wahres Label z durch unbekannte Mechanismen während des wenigstens einen Folgeprozesses zu y hin verändert wird bzw. gleich bleibt. Das besagte wahre Label entspricht dabei insbesondere dem prädizierten Vorliegen des Fehlers im Rahmen der Erfindung. Der Fall z = OK, y = NOK wäre dann Ersteres, also derjenige einer nachträglichen, unvorhersehbaren Zerstörung, die als "noisy Label" interpretiert würde. Beide parametrisierten Verteilungen sind insbesondere Teil eines Maschinenlernmodells zur Klassifikation unter verrauschten Labels und werden vorzugsweise in einer Trainingsphase desselben durch den Expectation-Maximization Algorithmus angepasst.

Der beschriebene Ansatz bietet aufgrund seiner Architektur und Lösungsalgorithmus (insbesondere durch den Expectation-Maximization-Algorithmus) die Möglichkeit durch probabilistische Inferenz den wahren Wert z eines Labels, bzw. dessen a posteri-Verteilung P(z|x,y) zu bestimmen und mit diesem dann das gemessene Label y während der Trainingsphase des Klassifikators zu ersetzen. Damit wird eine präzisere Vorhersage des schlussendlich gewollten Labels z möglich.

In einem Beispiel seien für eine Reihe von elektronischen Bauteilen 1, die für den finalen Test prädizierten Labels (0: OK, 1: NOK) gegeben. Nur in der Phase des finalen Tests sind diese beispielsweise durch Messung eindeutig und bekannt (y). In der Wafer-Test-Phase dagegen sind die (zu dieser Zeit) wahren Werte der Labels (z) insbesondere noch unbekannt und können sowohl aus den gemessenen Features (x), als auch den gemessenen Labels y des finalen Tests (retrospektiv) mittels eines Klassifikators erschlossen werden. Erschwert wird diese Aufgabe insbesondere durch unbekannte Fertigungsprozeduren beim Übergang von dem Wafer-Test zu dem finalen Test, wobei es zu einem Label-Flip, d.h. einem Übergang von z=0 auf y=1 kommen kann. Der verbleibende, erlaubte Label-Flip von z=0 zu y=1 kann dabei im Modell als "noisy label" durch die (gelernte) Wahrscheinlichkeit P(y=1|z=0) abgebildet werden.

In Fig. 2 gezeigt ist ein Bayesian Network, welches die Basis zum Klassifikator für verrauschte Labels gemäß der vorliegenden Erfindung bilden kann. Dabei wird das gemessene Label y insbesondere als verrauschte Version des wahren Werts des Labels z betrachtet und der Rauschprozess, d.h. das Umkippen eines Labels von z=0 zu y=1 und umgekehrt, als Noisy Channel modelliert, d.h. als Wahrscheinlichkeit P(y|z), die mittels nur zweier Parameter parametrisiert und gelernt werden kann. Der aus den gemessenen Features x ermittelte wahre Wert des Labels (z) wird vorzugsweise durch einen einfachen Klassifikator abgebildet, welcher der Verteilung P(z|x) entspricht.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

## Patentansprüche

1. Verfahren (100) zum Prädizieren eines zukünftigen Fehlers eines elektronischen Bauteils (1), umfassend die nachfolgenden Schritte:
- Bereitstellen (101) von Prüfdaten des elektronischen Bauteils (1), wobei die Prüfdaten aus einer elektrischen und/oder mechanischen Funktionsprüfung des elektronischen Bauteils (1) im Rahmen eines Wafer-Tests resultieren,
- Bestimmen (102) eines prädizierten Vorliegens eines Fehlers zum Zeitpunkt der Funktionsprüfung auf Basis der bereitgestellten Prüfdaten unter Verwendung eines trainierten Maschinenlernmodells, wobei das trainierte Maschinenlernmodell wenigstens einen Folgeprozesses nach dem Wafer-Test modelliert, wobei das prädizierte Vorliegen des Fehlers eine Wahrscheinlichkeit berücksichtigt, dass durch den wenigstens einen Folgeprozess ein Fehler des elektronischen Bauteils (1) hervorgerufen wird,
- Prädizieren (103) des zukünftigen Fehlers auf Basis des bestimmten prädizierten Vorliegens des Fehlers.

2. Verfahren (100) nach Anspruch 1,
**dadurch gekennzeichnet,**
**dass** das Maschinenlernmodell auf Basis eines Trainings mit den folgenden Schritten trainiert wurde:
- Bereitstellen von ersten Trainingsdaten, wobei die ersten Trainingsdaten im Rahmen einer elektrischen und/oder mechanischen Funktionsprüfung einer Vielzahl von elektronischen Bauteilen (1) im Rahmen eines Wafer-Tests ermittelt werden,
- Bereitstellen von zweiten Trainingsdaten, wobei die zweiten Trainingsdaten im Rahmen einer elektrischen und/oder mechanischen Funktionsprüfung der Vielzahl von elektronischen Bauteilen (1) im Rahmen einer finalen Prüfung nach dem wenigstens einen Folgeprozess nach dem Wafer-Test ermittelt werden,
- Ermitteln einer ersten Wahrscheinlichkeitsverteilung für eine Veränderung des Vorliegens des Fehlers vom Zeitpunkt des Wafer-Tests bis zum Zeitpunkt der finalen Prüfung auf Basis der bereitgestellten ersten und zweiten Trainingsdaten,
- Ermitteln einer zweiten Wahrscheinlichkeitsverteilung für ein jeweiliges prädiziertes Vorliegen des Fehlers zum Zeitpunkt der Funktionsprüfung im Rahmen des Wafer-Tests auf Basis der ersten und zweiten Trainingsdaten und der ersten Wahrscheinlichkeitsverteilung, wobei das prädizierte Vorliegen des Fehlers eine Wahrscheinlichkeit für die Veränderung des Vorliegens des Fehlers vom Zeitpunkt des Wafer-Tests bis zum Zeitpunkt der finalen Prüfung berücksichtigt.

3. Verfahren (100) nach Anspruch 2,
**dadurch gekennzeichnet,**
**dass** das Maschinenlernmodell ein Modell zur Klassifikation unter verrauschten Labels ist und in dem Training desselben durch einen Expectation-Maximization Algorithmus angepasst wird.

4. Verfahren (100) nach einem der Ansprüche 2 oder 3,
**dadurch gekennzeichnet,**
**dass** das Training unter Verwendung eines Boosted Tree-Verfahrens durchgeführt wird.

5. Verfahren (100) nach einem der Ansprüche 2 bis 4,
**dadurch gekennzeichnet,**
**dass** das Ermitteln der zweiten Wahrscheinlichkeitsverteilung auf Basis einer probabilistischen Inferenz durchgeführt wird.

6. Verfahren (100) nach einem der vorhergehenden Ansprüche,
**dadurch gekennzeichnet,**
**dass** der wenigstens eine Folgeprozess zumindest einen Verpackungsprozess des elektronischen Bauteils (1) umfasst.

7. Verfahren (100) nach einem der vorhergehenden Ansprüche,
**dadurch gekennzeichnet,**
**dass** das elektronische Bauteil (1) ein Halbleiterbauteil ist und die Funktionsprüfung im Rahmen einer Halbleiterfertigung durchgeführt wird.

8. Computerprogramm (20), umfassend Befehle, die bei der Ausführung des Computerprogramms (20) durch einen Computer (10) diesen veranlassen, das Verfahren (100) nach einem der vorhergehenden Ansprüche auszuführen.

9. Vorrichtung (10) zur Datenverarbeitung, die eingerichtet ist, das Verfahren (100) nach einem der Ansprüche 1 bis 7 auszuführen.

10. Computerlesbares Speichermedium (15), umfassend Befehle, die bei der Ausführung durch einen Computer (10) diesen veranlassen, die Schritte des Verfahrens (100) nach einem der Ansprüche 1 bis 7 auszuführen.

## Geänderte Patentansprüche

### Geänderte Patentansprüche gemäss Regel 137(2) EPÜ.

1. Verfahren (100) zum Prädizieren eines zukünftigen Fehlers eines elektronischen Bauteils (1), umfassend die nachfolgenden Schritte:
- Bereitstellen (101) von Prüfdaten des elektronischen Bauteils (1), wobei die Prüfdaten aus einer elektrischen und/oder mechanischen Funktionsprüfung des elektronischen Bauteils (1) im Rahmen eines Wafer-Tests resultieren,
- Bestimmen (102) eines prädizierten Vorliegens eines Fehlers zum Zeitpunkt der Funktionsprüfung auf Basis der bereitgestellten Prüfdaten unter Verwendung eines trainierten Maschinenlernmodells, wobei das trainierte Maschinenlernmodell wenigstens einen Folgeprozesses nach dem Wafer-Test modelliert, wobei das prädizierte Vorliegen des Fehlers eine Wahrscheinlichkeit berücksichtigt, dass durch den wenigstens einen Folgeprozess ein Fehler des elektronischen Bauteils (1) hervorgerufen wird, wobei die Wahrscheinlichkeit eine binäre Zufallsvariable (z) ist, die charakterisiert, ob ein funktionstüchtiges elektronisches Bauteil 1 im Folgeprozess zerstört wurde,
- Prädizieren (103) des zukünftigen Fehlers auf Basis des bestimmten prädizierten Vorliegens des Fehlers.

2. Verfahren (100) nach Anspruch 1,
**dadurch gekennzeichnet,**
**dass** das Maschinenlernmodell auf Basis eines Trainings mit den folgenden Schritten trainiert wurde:
- Bereitstellen von ersten Trainingsdaten, wobei die ersten Trainingsdaten im Rahmen einer elektrischen und/oder mechanischen Funktionsprüfung einer Vielzahl von elektronischen Bauteilen (1) im Rahmen eines Wafer-Tests ermittelt werden,
- Bereitstellen von zweiten Trainingsdaten, wobei die zweiten Trainingsdaten im Rahmen einer elektrischen und/oder mechanischen Funktionsprüfung der Vielzahl von elektronischen Bauteilen (1) im Rahmen einer finalen Prüfung nach dem wenigstens einen Folgeprozess nach dem Wafer-Test ermittelt werden,
- Ermitteln einer ersten Wahrscheinlichkeitsverteilung für eine Veränderung des Vorliegens des Fehlers vom Zeitpunkt des Wafer-Tests bis zum Zeitpunkt der finalen Prüfung auf Basis der bereitgestellten ersten und zweiten Trainingsdaten,
- Ermitteln einer zweiten Wahrscheinlichkeitsverteilung für ein jeweiliges prädiziertes Vorliegen des Fehlers zum Zeitpunkt der Funktionsprüfung im Rahmen des Wafer-Tests auf Basis der ersten und zweiten Trainingsdaten und der ersten Wahrscheinlichkeitsverteilung, wobei das prädizierte Vorliegen des Fehlers eine Wahrscheinlichkeit für die Veränderung des Vorliegens des Fehlers vom Zeitpunkt des Wafer-Tests bis zum Zeitpunkt der finalen Prüfung berücksichtigt.

3. Verfahren (100) nach Anspruch 2,
**dadurch gekennzeichnet,**
**dass** das Maschinenlernmodell ein Modell zur Klassifikation unter verrauschten Labels ist und in dem Training desselben durch einen Expectation-Maximization Algorithmus angepasst wird.

4. Verfahren (100) nach einem der Ansprüche 2 oder 3,
**dadurch gekennzeichnet,**
**dass** das Training unter Verwendung eines Boosted Tree-Verfahrens durchgeführt wird.

5. Verfahren (100) nach einem der Ansprüche 2 bis 4,
**dadurch gekennzeichnet,**
**dass** das Ermitteln der zweiten Wahrscheinlichkeitsverteilung auf Basis einer probabilistischen Inferenz durchgeführt wird.

6. Verfahren (100) nach einem der vorhergehenden Ansprüche,
**dadurch gekennzeichnet,**
**dass** der wenigstens eine Folgeprozess zumindest einen Verpackungsprozess des elektronischen Bauteils (1) umfasst.

7. Verfahren (100) nach einem der vorhergehenden Ansprüche,
**dadurch gekennzeichnet,**
**dass** das elektronische Bauteil (1) ein Halbleiterbauteil ist und die Funktionsprüfung im Rahmen einer Halbleiterfertigung durchgeführt wird.

8. Computerprogramm (20), umfassend Befehle, die bei der Ausführung des Computerprogramms (20) durch einen Computer (10) diesen veranlassen, das Verfahren (100) nach einem der vorhergehenden Ansprüche auszuführen.

9. Vorrichtung (10) zur Datenverarbeitung, die eingerichtet ist, das Verfahren (100) nach einem der Ansprüche 1 bis 7 auszuführen.

10. Computerlesbares Speichermedium (15), umfassend Befehle, die bei der Ausführung durch einen Computer (10) diesen veranlassen, die Schritte des Verfahrens (100) nach einem der Ansprüche 1 bis 7 auszuführen.
